# EUROPÄISCHE PATENTSCHRIFT

(11) **EP 2 056 333 B1**
(45) Veröffentlichungstag und Bekanntmachung des Hinweises auf die Patenterteilung: **24.08.2016**
(21) Anmeldenummer: 07021097.6
(22) Anmeldetag: 29.10.2007
(51) Int. Cl.: H01J 49/14, H01J 49/10, H01J 49/00, H01J 37/08

(54) **Flüssigmetallionenquelle, Sekundärionenmassenspektrometer, sekundärionenmassenspektrometisches Analyseverfahren sowie deren Verwendungen**
Liquid metal ion source, secondary ion mass spectrometer, secondary ion mass spectrometric analysis procedure and their applications
Source ionique de métal liquide, spectromètre de masse ionique secondaire, procédé d'analyse à spectromètre de masse ionique secondaire, ainsi que leurs utilisations

(43) Veröffentlichungstag der Anmeldung: 06.05.2009
(73) Patentinhaber: ION-TOF Technologies GmbH, 48149 Münster (DE)
(72) Erfinder: Kollmer, Felix Dr., 48341 Altenberge (DE); Hoerster, Peter, 48149 Münster (DE); Dütting, Andreas, 48653 Coesfeld (DE)
(74) Vertreter: Pfenning, Meinig & Partner mbB

(56) Entgegenhaltungen:
- DE-A1- 10 339 346
- NOOTHOVEN VAN GOOR, J.M., ZIJLSTRA, H.: "Structural and magnetic properties of a Bi-MnBi Composite" JOURNAL OF APPLIED PHYSICS, Bd. 39, Nr. 12, November 1968 (1968-11), Seiten 5471-5474, XP002471180
- KLEPPA, O.J.: "A thermodynamic study of liquid metallic solutions. IV. Approximate thermodynamic data from the phase diagram for the systems copper-bismuth, copper-lead and copper-thallium" JOURNAL OF THE AMERICAN CHEMICAL SOCIETY, Bd. 74, 5. Dezember 1952 (1952-12-05), Seiten 6047-6051, XP002471181
- GILMORE I ET AL: "Static SIMS: towards unfragmented mass spectra - the G-SIMS procedure", APPLIED SURFACE SCIENCE, ELSEVIER, AMSTERDAM, NL, vol. 161, no. 3-4, 2 July 2000 (2000-07-02), pages 465-480, XP027317453, ISSN: 0169-4332 [retrieved on 2000-07-02]

## Beschreibung

Die vorliegende Erfindung betrifft eine Flüssigmetallionenquelle, ein Sekundärionenmassenspektrometer sowie ein sekundärionenmassenspektrometrisches Analyseverfahren sowie deren Verwendungen.

Sekundärionenmassenspektrometrie wird unter anderem als sog. statische Sekundärionenmassenspektrometrie (SSIMS) betrieben. Dabei wird ein energiereicher Pri-märionenstrahl auf eine zu analysierende Oberfläche eines Substrates gerichtet. Beim Auftreffen auf das Substrat schlägt der Primärionenstrahl sog. Sekundärionen aus dem Material, die anschließend analysiert werden. Aus dieser Analyse lässt sich das Material der Oberfläche bestimmen. Um Informationen der Verteilung bestimmter Stoffe über die Oberfläche zu erhalten, kann der Primärionenstrahl die Oberfläche abscannen. Um Tiefeninformationen zu erhalten, wird der Strahl auf eine bestimmte Stelle der Oberfläche gerichtet und trägt diese im Lauf der Zeit ab, so dass auch tiefer liegende Schichten freigelegt und analysiert werden können. Auch eine Kombination des Abscannens der Oberfläche mit einer Tiefenprofilanalyse ist möglich.

Ein herkömmliches statisches sekundärionenmassenspektrometrisches Verfahren ist beispielsweise in der DE 103 39 346 A1 offenbart.

Seit einiger Zeit steht zur Analyse von Oberflächen auch das in der Fachwelt unter dem Namen Gentle Sekundärionenmassenspektrometrie (Gentle SIMS bzw. G-SIMS) genannte Verfahren zur Verfügung. Dieses wird beispielsweise in I.S. Gilmore et al. "Static SIMS: towards unfragmented mass spectra - the G-SIMS procedure", Applied Surface Science 161 (2000) S. 465-480 beschrieben.

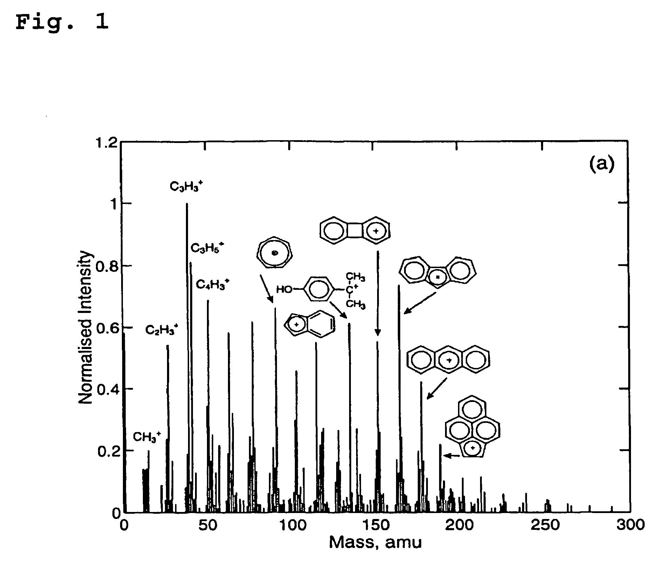

Dieses als G-SIMS bezeichnete Verfahren wurde im Jahre 1999 von I.S. Gilmore vorgestellt. Ziel der Anwendung des G-SIMS-Verfahrens ist es, die Komplexität eines TOF-SIMS-Spektrums (Flugzeiten Massenspektrometrie) zu verringern und die Interpretation zu vereinfachen. Denn ein TOF-SIMS-Spektrum weist eine große Anzahl von Sekundärionen-Linien/-Peaks auf. Ein solches sekundärionenmassenspektrometrisches Spektrum ist in Figur 1 gezeigt. Neben den charakteristischen Linien für die hier untersuchte Polycarbonatprobe weist dieses Spektrum eine Vielzahl intensiver unspezifischer Signale, wie beispielsweise polycyclische aromatische Kohlenwasserstoffe auf. Die konventionelle Interpretation eines solchen Spektrums setzt eine entsprechende Erfahrung voraus. Zur Interpretation sind zusätzlich Spektrenbibliotheken hilfreich. Da die Beschussbedingungen jedoch einen starken Einfluss auf die relativen Peak-Intensitäten eines TOF-SIMS-Spektrums haben, können Spektren derselben Substanz deutlich voneinander abweichen. Mit zunehmender Vielfalt von Primärionenquellen und Verwendung unterschiedlicher Beschussbedingungen ist der Aufbau einer Spektrenbibliothek zunehmend schwieriger.

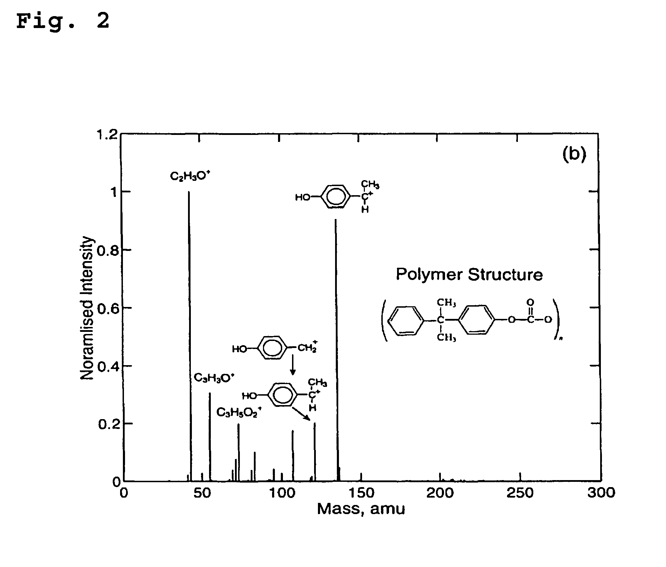

Figur 2 zeigt nun das gleiche TOF-SIMS-Spektrum wie in Figur 1, jedoch nach Anwendung des G-SIMS-Verfahrens. Unmittelbar ersichtlich ist, dass das Spektrum sehr stark vereinfacht ist. Charakteristische Peaks werden hervorgehoben, während unspezifische Fragmente unterdrückt werden. Dies erleichtert die Identifizierung molekularer Gruppen und die Interpretation des Spektrums gegenüber dem konventionellen TOF-SIMS-Spektrum erheblich. Die Anwendung des G-SIMS-Algorithmus ermöglicht also dem Experten einen schnellen Überblick und liefert zusätzliche Informationen, um eine zuverlässige Interpretation der Daten zu erreichen. Auch dem weniger erfahrenen Nutzer wird ein leichterer Zugang zur Interpretation der Daten ermöglicht.

Da G-SIMS-Spektren nur eine geringe Abhängigkeit von den Beschussbedingungen aufweisen, ist der Aufbau von Spektrenbibliotheken für die G-SIMS-Prozedur erheblich leichter als für das herkömmliche TOF-SIMS-Verfahren.

Das G-SIMS-Verfahren setzt nun die Existenz zweier Spektren mit stark unterschiedlichem Fragmentierungsverhalten voraus. Dieses Fragmentierungsverhalten lässt sich sehr stark durch die Energie und die Masse der verwendeten Primärionen beeinflussen. Insbesondere der Einfluss der Primärionenmasse auf das Fragmentierungsverhalten ist von Bedeutung. Denn in aller Regel nimmt die Fragmentierung mit steigender Masse des Primärions ab. Die stärkste Fragmentierung lässt sich demgegenüber durch die Wahl leichter hochenergetischer atomarer Primärionen erreichen. Durch die Wahl schwerer monoatomarer oder polyatomarer Beschussteilchen wird also das Emissionsspektrum generell zu höheren Massen verschoben und die Fragmentierung deutlich verringert. Uncharakteristische Fragment-Peaks reagieren also deutlich stärker auf die veränderten Beschussbedingungen als probenspezifische, molekulare Signale.

Beim G-SIMS-Verfahren, das in der oben genannten Druckschrift von I. S. Gilmore et al. mit mehr Details beschrieben ist, als hier erwähnt werden können, werden zwei Spektren mit stark unterschiedlichem Fragmentierungsverhalten aufgenommen. Nach geeigneter Normierung werden die Spektren so dividiert, dass Signale, die sich in beiden Spektren stark unterscheiden, unterdrückt werden. Signale, die nur einen geringen Unterschied in beiden Spektren aufweisen, werden entsprechend verstärkt. Eine anschließende Potenzierung des Quotienten beider Spektren verstärkt diese Effekte nochmals deutlich.

Das G-SIMS-Verfahren findet zwar große Beachtung, jedoch im praktischen Laboreinsatz bis heute nur eine geringe Akzeptanz. Dies liegt u.a. darin, dass der experimentelle Aufwand für dieses Verfahren sehr groß ist. Denn die erforderlichen Spektren mit stark unterschiedlichem Fragmentierungsverhalten können bisher nur durch den Einsatz unterschiedlicher Analysequellen erreicht werden.

Zum einen stehen Gasionenquellen zur Verfügung, die prinzipiell in der Lage sind, eine Reihe unterschiedlich schwerer atomarer Primärionen (Ar, Ne, Xe) als auch polyatomarer Primärionen zu erzeugen (SF₅). Der Wechsel zwischen verschiedenen Spezies an Primärionen ist bei diesen Gasquellen jedoch sehr aufwändig. Darüber hinaus liefern diese Quellen nur eine eingeschränkte Performance im Hinblick auf die erreichbare laterale Auflösung und Massenauflösung.

Alternativ können gleichzeitig mehrere unterschiedliche Primärionenquellen (z.B. mit Ga oder SF₅) betrieben werden. Dies erfordert jedoch einen hohen apparativen Aufwand, wobei die erreichbare Performance einer derartigen G-SIMS-Analyse durch die Schwächste der zum Einsatz kommenden Quellen limitiert ist. Die benötigten Spektren können hier nur nacheinander akquiriert werden, so dass der zeitliche Aufwand sehr groß ist.

Es wurden auch kommerziell verfügbare Cluster-Quellen mit Au bzw. Bi als Emittermaterial vorgeschlagen. Die Emissionsspektren derartiger Quellen weisen sowohl atomare als auch intensive polyatomare Spezies auf. Es zeigte sich jedoch rasch, dass die benötigte starke Variation der Fragmentierung mit diesen Quellen nicht erreicht werden konnte. Denn die Verwendung der Cluster als Analysespezies führt zwar zu Spektren geringer Fragmentierung, wie sie für die erfolgreiche Anwendung der G-SIMS-Prozedur notwendig sind. Die maximale Fragmentierung wird in diesem Falle jedoch durch die Verwendung der atomaren Spezies erreicht, wobei aufgrund der großen Masse des Au bzw. Bi im monoatomaren Primärionenstrahl die Fragmentierung relativ gering ist und die erreichbare Variation der Fragmentierung zwischen der Anwendung der Cluster als Primärionenstrahl und der Anwendung der monoatomaren Primärionen als Primärionenstrahl nicht ausreicht.

Bisher sind daher keinerlei Primärionenquellen bekannt, die sich für eine erfolgreiche Durchführung des G-SIMS-Verfahrens eignen würden.

Die Druckschrift Noothoven van Goor, J.M., Zijlstra, H. "Structural and magnetic properties of Bi-MnBi Composite" Journal of Applied Physics, Bd. 39, Nr. 12, November 1968 (1968-11), Seiten 5471-5474, XP002471180 betrifft die Untersuchung von MnBi-Nadeln, die in Bismuteinkristalle eingebettet sind, bezüglich ihrer strukturellen, galvanomagnetischen und magnetischen Eigenschaften.

Die Druckschrift Kleppa, O.J. "A thermodynamic study of liquid metallic solutions. IV. Approximate thermodynamic data from the phase diagram for the systems copper-bismuth, copper-lead and copper-thallium" Journal of the American Chemical Society, Bd. 74, 5. Dezember 1952 (1952-12-05), Seiten 6047-6051, XP002471181 offenbart eine thermodynamische Untersuchung von flüssigen Metalllösungen von Kupfer in Bismut, Blei und Thallium. Ziel dieser Untersuchung ist es, thermodynamische Daten über diese Lösungssysteme aus deren Phasendiagramm zu gewinnen.

Die vorliegende Erfindung setzt sich daher zur Aufgabe, neue Ionenquellen zur Verfügung zu stellen, die vorteilhaft in der Sekundärionenmassenspektrometrie eingesetzt werden können. Sie setzt sich weiterhin zur Aufgabe, ein vorteilhaftes Sekundärionenmassenspektrometer sowie ein massenspektrometrisches Analyseverfahren zur Verfügung zu stellen.

Diese Aufgabe wird durch die Flüssigmetallionenquelle nach Anspruch 1 oder 3, das Sekundärteilchenmassenspektrometer nach Anspruch 13 und das sekundärteilchenmassenspektrometrische Analyseverfahren nach Anspruch 20 gelöst. Vorteilhafte Weiterbildungen der erfindungsgemäßen Flüssigmetallionenquelle, des erfindungsgemäßen Sekundärteilchenmassenspektrometers und des erfindungsgemäßen sekundärteilchenmassenspektrometrischen Analyseverfahrens sowie Verwendungen hierfür werden in den jeweiligen hiervon abhängigen Ansprüchen gegeben.

Die vorliegende Erfindung stellt ein sekundärteilchenmassenspektrometrisches Analyseverfahren zur Verfügung, bei dem abwechselnd verschiedene gefilterte Primärionenstrahlen erzeugt werden. Dabei wird eine Primärionenquelle eingesetzt, die zum einen monoatomare oder polyatomare Ionen eines ersten schweren Metalls mit einem Atomgewicht ≥ 190 u als auch monoatomare Ionen eines weiteren leichten Metalls mit einem Atomgewicht ≤ 90 u erzeugt. Erfindungsgemäß wird aus diesem Primärionenstrahl mittels einer Filtereinrichtung ein jeweils weitgehend bzw. vollständig massenreiner gefilterter Primärionenstrahl ausgefiltert (Filterung nach Masse und Ladung des auszufilternden Ionenspezies). Dieser gefilterte Primärionenstrahl enthält entweder die monoatomaren oder polyatomaren Ionen des ersten Metalls oder die Ionen des weiteren Metalls. Auf diese Weise werden abwechselnd aus derselben Ionenquelle zwei Primärionenstrahlen zur Verfügung gestellt, die nach Filterung eine sehr unterschiedliche Fragmentierung der zu analysierenden Probe bewirken, selbst wenn für die unterschiedlichen gefilterten Primärionenstrahlen gleiche oder ähnliche Beschleunigungsspannungen verwendet werden. Mittels eines derartigen erfindungsgemäßen Verfahrens ist es möglich, neben den herkömmlichen statischen Sekundärionenmassenspektrometrien auch die erst kürzlich entwickelte Gentle-SIMS-Spektroskopie durchzuführen. Insbesondere erfüllt dieses Verfahren in idealer Weise die Anforderungen, dass ohne große zeitliche Verluste, wie z.B. Wechsel der Ionenquelle, zwei stark unterschiedlich fragmentierte Spektren ermittelt und anschließend ausgewertet werden können. Die in diesem Verfahren eingesetzte Primärionenquelle deckt also den Bereich leichter atomarer Primärionen bis hin zu schweren polyatomaren Primärionen unterschiedlicher Ladungszustände vollständig ab.

Für den Fall einer G-SIMS-Analyse mit dem erfindungsgemäßen Analyseverfahren lässt sich dieses Verfahren wie folgt darstellen:
Die Flüssigmetallionenquelle emittiert Primärionen zweier unterschiedlicher Metalle M1 und M2. Die für die Analyse verwendeten Ionen der Spezies M1 weisen eine Masse > 190 u auf und sind mono- oder polyatomar. Die verwendeten Ionen der Spezies M2 besitzen eine Masse < 90 u und sind monoatomar.

Zur G-SIMS-Analyse wird die Oberfläche zunächst mit einem sortenreinen Ionenstrahl entweder der Masse M1 oder der Masse M2 analysiert. Die Primärionendosis wird dabei so gering gehalten, dass keine nennenswerte Schädigung der Oberfläche stattfindet (statischer Beschussbereich). Anschließend wird die Oberfläche mit der zuvor nicht verwendeten Spezies M1 oder M2 analysiert. Der Wechsel zwischen den Primärionenarten kann dabei mehrmals erfolgen.

Die durch die Analyse mit M1 und M2 entstandenen Sekundärionenspektren werden anschließend gemäß dem G-SIMS-Verfahren behandelt. Durch Anwendung des G-SIMS-Algorithmus werden die beiden Sekundärionenspektren zu einem G-SIMS-Spektrum zusammengeführt.

Durch die Möglichkeit der schnellen und wiederholten Umschaltung zwischen den Massen M1 und M2 kann das G-SIMS-Spektrum bereits während der Analyse erzeugt werden.

In einer erfindungsgemäßen Flüssigmetallionenquelle weist das weitere Metall eine Isotopieverteilung auf, bei der das natürliche oder angereicherte Hauptisotop in der Flüssigmetallionenquelle einen Anteil ≥ 80 %, vorteilhafterweise ≥ 90 %, vorteilhafterweise ≥ 95 % am Gesamtanteil des weiteren Metalls in dem Emissionsspektrum der Flüssigmetallionenquelle aufweist.

Der Anteil gemischter Cluster aus erstem Metall und weiterem Metall in dem von der Flüssigmetallionenquelle emittierten Primärionenstrahl vor der Filterung soll vorteilhafterweise ≤ 10 %, bezogen auf das gesamte Emissionsspektrum betragen.

Der Anteil der Ionen des ersten Metalls, insbesondere von Bismutionen, in der erfindungsgemäßen Flüssigmetallionenquelle und/oder an dem emittierten Primärionenstrahl beträgt vorteilhafterweise ≥ 50 %, vorteilhafterweise ≥ 90 %. Als erstes Metall eignet sich vorteilhafterweise eines der Metalle Bismut, Gold und Blei oder Mischungen hiervon.

Der Anteil der Ionen des weiteren Metalls, insbesondere des Mangans, an der Flüssigmetallionenquelle und/oder an dem von der Flüssigmetallionenquelle emittierten Primärionenstrahl vor Filterung beträgt vorteilhafterweise ≥ 0,5 %, vorteilhafterweise ≥ 2 %. Er ist vorteilhafterweise nach oben auf ≤ 50 %, vorteilhafterweise ≤ 10 % an der Flüssigmetallionenquelle und/oder dem emittierten Primärionenstrahl vor Filterung der Flüssigmetallionenquelle begrenzt.

Zusammen beträgt vorteilhafterweise der Anteil der Ionen des ersten Metalls, insbesondere der Bismutionen, gemeinsam mit dem Anteil der Ionen des weiteren Metalls, vorteilhafterweise des Mangans, an der Metalllegierung der Flüssigmetallionenquelle und/oder an dem primär emittierten Primärionenstrahl vor Filterung ≥ 90 %, vorteilhafterweise ≥ 95 %, vorteilhafterweise ≥ 98 %.

Als Metall eignet sich hierbei vorteilhafterweise eines der Metalle Wismut, Gold und Blei oder Mischungen hiervon.

Generell werden vorteilhafterweise als weiteres Metall mit niedrigem Atomgewicht Metalle verwendet, deren Löslichkeit in dem ersten Metall mit hohem Atomgewicht ≥ 1 % beträgt und die eine schmale Isotopieverteilung aufweisen. Ein weiteres vorteilhaftes Auswahlkriterium für die Wahl des weiteren Metalls mit niedrigem Atomgewicht ist, dass es bei der Ionenstrahlerzeugung kleine oder nur geringe Mengen gemischter Cluster mit dem ersten Metall mit hohem Atomgewicht bildet.

Als weiteres Metall, das ein Atomgewicht ≤ 90 u aufweist, eigenen sich insbesondere die folgenden Metalle oder Mischungen hiervon: Lithium, Beryllium, Bor, Natrium, Magnesium, Aluminium, Silizium, Kalium, Calcium, Scandium, Titan, Vanadium, Chrom, Mangan, Eisen, Kobalt, Nickel, Kupfer, Zink, Gallium, Germanium, Arsen, Selen, Rubidium und Yttrium.

Besonders vorteilhaft wird als erstes Metall mit hohem Atomgewicht ≥ 190 u Bismut verwendet, wobei aus dem Primärionenstrahl vorteilhafterweise eine von mehreren Bismutionenarten, deren Masse etwa oder genau ein Mehrfaches des monoatomaren, ein- oder mehrfach geladenen Bismutions beträgt, als massenreiner gefilterter Primärionenstrahl ausgefiltert wird. Als weiteres Metall hat sich besonders vorteilhaft Mangan erwiesen, wobei Mangan als weiteres Metall mit geringem Atomgewicht ≤ 90 u für die Ausfilterung des gefilterten Primärionenstrahls mit hoher Fragmentierung zur Verfügung steht.

Mit Bismut als erstem Metall enthält der Primärionenstrahl nach Filterung und Auswahl Ionen des ersten schweren Metalls mit einem Atomgewicht ≤ 190, vorteilhafterweise Bismutionen Biₙ^{p+} einer einzigen Art, bei denen n ≥ 2 und p ≥ 1 ist und n und p jeweils eine natürliche Zahl ist, vorteilhafterweise enthält der gefilterte Primärionenstrahl

Bi₃⁺-Ionen oder B₃²⁺-Ionen oder er besteht aus derartigen Ionen.

Die Analyse der erzeugten Sekundärteilchen kann vorteilhafterweise mit einem magnetischen Sektorfeldmassenspektrometer, einem Quadrupol-Massenspektrometer oder einem Flugzeitmassenspektrometer erfolgen, wobei sowohl für die statische Sekundärionenmassenspektrometrie mit einer der erfindungsgemäßen Flüssigmetallionenquellen oder einem der erfindungsgemäßen Sekundärionenmassenspektrometer sowohl ein Bild der Probenoberfläche, beispielsweise durch Scannen, als auch ein Tiefenprofil der Probenoberfläche oder auch eine Kombination hiervon bestimmt werden kann. Dies gilt auch für das erfindungsgemäße Verfahren, insbesondere wenn es in einem G-SIMS-Verfahren angewandt wird.

Im Folgenden werden einige Beispiele erfindungsgemäßer Verfahren gegeben. Es zeigen
- Figur 1: ein TOF-SIMS-Spektrum von Polycarbonat, aufgenommen mit Argon-Ionen mit einer Energie von 10 keV als Primärionenspezies;
- Figur 2: ein G-SIMS-Spektrum von Polycarbonat aufgenommen mit Cäsium-Ionen mit einer Energie von 10 keV und Argon-Ionen mit einer Energie von 10 keV als Primärionenspezies;
- Figur 3: ein Emissionsspektrum eines BiMn-Emitters im unteren Massenbereich;
- Figur 4: ein G-SIMS-Spektrum von Polycarbonat aufgenommen mit einer BiMn-Flüssigmetallionenquelle mit Mangan-Ionen mit einer Energie von 25 keV und Bi₃-Ionen mit einer Energie von 25 keV als Primärionenspezies.

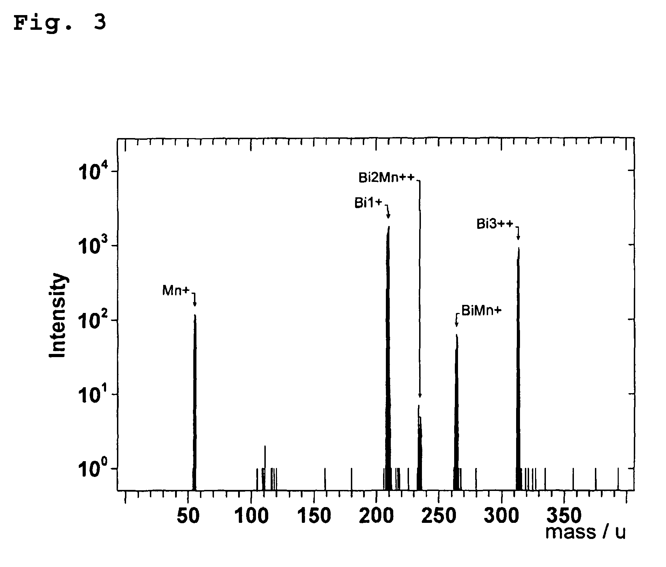

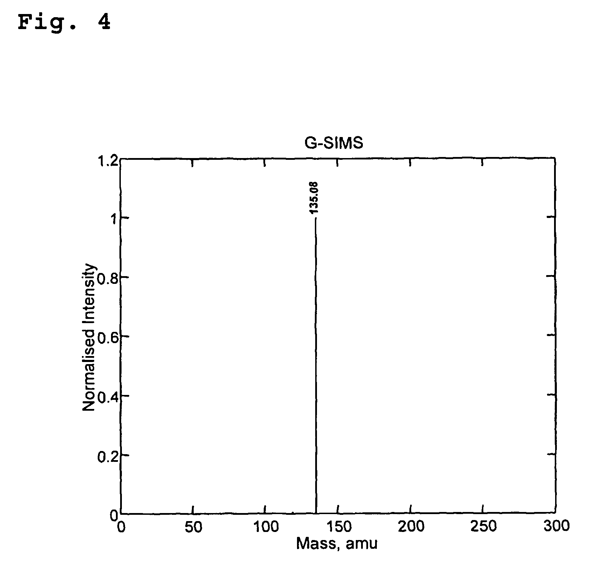

Für die Durchführung der erfindungsgemäßen Beispiele, wie sie in den Figuren 3 und 4 dargestellt sind, wurde eine Bismut-Flüssigmetallionen-Cluster-Quelle verwendet, die 95 % Bismut und 5 % Mangan in der Legierung enthielt.

Erfindungsgemäß hat sich herausgestellt, dass sich aufgrund der schweren und intensiven Cluster und der unterschiedlichen Ladungszustände Bismut-Cluster-Quellen in idealer Weise eignen, um die Fragmentierung im Spektrum eines S-SIMS-Verfahrens oder eines G-SIMS-Verfahrens zu variieren. Die maximal erzielbare Variation der Fragmentierung ist jedoch bei Verwendung einer reinen Bismut-Cluster-Quelle noch zu gering.

Daher wurde bei den vorliegenden Beispielen dem Bismut-Emitter ein möglichst leichter Legierungsbestandteil zugesetzt, der im unteren Massenbereich des Emissionsspektrums atomare Primärionen emittiert. Das zugesetzte Element wurde hier aufgrund einer Reihe von Randbedingungen ausgewählt:
Als leichter Legierungsbestandteil wurde Mangan verwendet. Dieses weist ebenso wie Bismut ausschließlich ein einzelnes Isotop auf und bildet prinzipiell eine Legierung mit Bismut. Es ist zu wenigstens einigen Prozent in Bismut löslich, wobei der Anteil des Mangans am Emissionsspektrum des Emitters im Wesentlichen dem stöchiometrischen Anteil in der Legierung der Flüssigmetallionenquelle entspricht. Dies verhindert An- und Abreicherungsprozesse des Mangans im Verlauf der Messung. Es treten auch lediglich geringe Intensitäten gemischter Cluster aus Bismut und Mangan auf. Dies verhindert, dass die erzielbare Intensität der gewünschten atomaren Spezies durch Bildung gemischter Cluster verringert wird und die Nutzbarkeit der emittierten reinen Bismut-Cluster durch die Anwesenheit gemischter Bismut-Mangan-Cluster eingeschränkt wird.

Figur 3 zeigt nun das Emissionsspektrum des Bismut-Mangan-Emitters gemäß der vorliegenden Erfindung. Dieses zeigt offensichtlich die erhofften Eigenschaften, denn die Intensität der Bismut-Emission mit ca. 96 % und der Mangan-Emission mit ca. 4 % entspricht im Rahmen der Messgenauigkeit der stöchiometrischen Zusammensetzung der Legierung.

Es zeigt sich in Figur 3, dass Mangan im Wesentlichen als atomares Ion, insbesondere als Mn⁺ bzw. Mn²⁺ emittiert wird. Masseninterferenzen mit den Bismut-Clustern im oberen Massenbereich treten kaum auf. Durch die geringe zugesetzte Menge an Mangan wird die Intensität der emittierten Bismut-Cluster durch mögliche gemischte Cluster aus Bismut und Mangan kaum reduziert. Die mit der in Figur 3 verwendeten Quelle auftretenden Verluste bezüglich der Bismut-Cluster sind für den Betrieb als Bismut-Cluster-Quelle auch ohne Bedeutung.

Für Polycarbonat zeigt nun Figur 4 das G-SIMS-Spektrum, aufgenommen mit der erwähnten BiMn-Flüssigmetallionenquelle. Als Primärionenspezies wurden dabei Mn⁺-Ionen und Bi₃⁺-Ionen verwendet, wobei aus dem erzeugten Primärionenstrahl der BiMn-Quelle abwechselnd durch Änderung der Filterparameter ein massereiner Primärionenstrahl von Mn⁺-Ionen (25 keV) und ein massereiner Primärionenstrahl von Bi₃⁺-Ionen (25 keV) erzeugt wurde. In Figur 2 ist nun unmittelbar die Dominanz des charakteristischen Peaks der Masse 135 u gegenüber dem ursprünglichen Referenzspektrum, wie es in Figur 2 gezeigt ist, nochmals deutlich erhöht.

Die mit diesem erfindungsgemäßen BiMn-Emitter erzielten Ergebnisse sind durchweg positiv. Die erhaltenen G-SIMS-Spektren erfüllen alle Kriterien, die an ein erfolgreiches G-SIMS-Spektrum zu stellen sind. Dies ist beispielsweise im Falle von Polycarbonat die Dominanz des charakteristischen Peaks der Masse 135 u im Gesamtspektrum.

Es zeigt sich hier also auch experimentell, dass sich die erfindungsgemäßen Flüssigmetallionenquellen und insbesondere das erfindungsgemäße massenspektroskopische Analyseverfahren hervorragend für die Massenspektroskopie, insbesondere das G-SIMS-Verfahren eignen.

Der grundlegende Vorteil eines derartigen gemischten Emitters, hier beispielsweise des BiMn-Emitters, besteht darin, dass die Sekundärionenmassenspektrometrie, insbesondere neben dem statischen SIMS-Verfahren auch das G-SIMS-Verfahren, mit nur einer Quelle und ohne Wechsel des Betriebsmittel durchgeführt werden kann.

Darüber hinaus weist die erfindungsgemäße Flüssigmetallionenquelle und das erfindungsgemäße Verfahren einige weitere prinzipielle Vorteile im Hinblick auf die Verwendung für das G-SIMS-Verfahren auf.

Die erfindungsgemäße Flüssigmetallionenquellen, Spektrometer und Verfahren nutzen zur Massenfilterung die unterschiedliche Flugzeit verschiedener Spezies aus. Die Flugzeit-Massenfilterung erlaubt nun nahezu beliebig schnelles Umschalten zwischen verschiedenen Primärionenspezies. Aufgrund der gewählten Realisierung bleibt die Massenkalibration des Spektrums beim Umschalten der Primärspezies erhalten. Die Anordnung bietet somit die Voraussetzung, um das G-SIMS-Spektrum direkt, bereits nach wenigen Analysezyklen, fortwährend berechnen und anzeigen zu können. Somit ist eine quasi-simultane Analyse der Probe mit unterschiedlichen Primärionen möglich. Die aufwendige sequentielle Analyse mit unterschiedlichen Quellen ist nicht mehr nötig. Selbst TOF-SIMS-Bilder der Probenoberfläche können auf diese Art bereits nach mindestens zwei Bilddurchläufen als G-SIMS-Bild dargestellt werden. Die quasi-simultane Analyse erlaubt zudem Betriebsarten, die bislang für G-SIMS nicht denkbar waren, z.B. die Tiefenprofilierung organischer Oberflächen.

Insbesondere bei der Tiefenprofilierung bzw. bei der gerasterten Abtastung (Scannen) einer Oberfläche wurde beim Verfahren nach dem Stand der Technik, bei dem zuerst eine Analyse der Probe mit einer der Primärionenspezies aus einer spezifischen Quelle untersucht wurde, diese Probenoberfläche während des Beschusses massiv verändert. Die nachfolgende nach Umbau der Ionenquelle auf die andere Ionenspezies erfolgte Analyse derselben Probenoberfläche führt zwangsläufig zu veränderten Ergebnissen, da die Probenoberfläche für diese zweite Ionenspezies nur noch in veränderter Form zur Verfügung stand. Mit dem erfindungsgemäßen Verfahren wird jetzt jedoch aufgrund der raschen Umschaltung zwischen den einzelnen Primärionenspezies und der damit quasi simultanen Analyse eine Charakterisierung derselben Oberfläche im selben Zustand möglich.

## Patentansprüche

1. Flüssigmetallionenquelle, die Bismut in einer Legierung enthält, wobei die Legierung ein weiteres Metall mit einem Atomgewicht ≤ 90 u enthält, **dadurch gekennzeichnet, dass** das natürliche oder angereicherte Hauptisotop einen Anteil > 80 % am Gesamtanteil des weiteren Metalls in der Flüssigmetallionenquelle aufweist.

2. Flüssigmetallionenquelle nach dem vorhergehenden Anspruch, **dadurch gekennzeichnet, dass** sie Mangan als weiteres Metall enthält.

3. Flüssigmetallionenquelle nach einem der vorhergehenden Ansprüche, **dadurch gekennzeichnet, dass** das natürliche oder angereicherte Hauptisotop des weiteren Metalls einen Anteil ≥ 90 %, vorteilhafterweise ≥ 95 % am Gesamtanteil des weiteren Metalls in der Flüssigmetallionenquelle aufweist.

4. Flüssigmetallionenquelle nach einem der vorhergehenden Ansprüche, **dadurch gekennzeichnet, dass** der Bismutgehalt in der Legierung ≥ 50 %, vorteilhafterweise ≥ 90 % ist.

5. Flüssigmetallionenquelle nach einem der vorhergehenden Ansprüche, **dadurch gekennzeichnet, dass** der Gehalt des weiteren Metalls in der Legierung ≥ 0,5 % vorteilhafterweise ≥ 2 % ist.

6. Flüssigmetallionenquelle nach einem der vorhergehenden Ansprüche, **dadurch gekennzeichnet, dass** der Gehalt des weiteren Metalls in der Legierung ≤ 50 %, vorteilhafterweise ≤ 10 % ist.

7. Flüssigmetallionenquelle nach einem der vorhergehenden Ansprüche, **dadurch gekennzeichnet, dass** Bismut und das weitere Metall zusammen in der Legierung einen Anteil von ≥ 90 %, vorteilhafterweise ≥ 95 %, vorteilhafterweise ≥ 98 % besitzen.

8. Flüssigmetallionenquelle nach einem der vorhergehenden Ansprüche, **dadurch gekennzeichnet, dass** die Legierung eine niedrigschmelzende, Bismut enthaltende Legierung ist.

9. Flüssigmetallionenquelle nach einem der vorhergehenden Ansprüche, **dadurch gekennzeichnet, dass** die Legierung einen Schmelzpunkt unterhalb des Schmelzpunktes des reinen Bismuts bzw. ≤ 270 °C aufweist.

10. Flüssigmetallionenquelle nach einem der vorhergehenden Ansprüche, **dadurch gekennzeichnet, dass** die metallische Legierung eine Legierung ist mit Ni, Cu, Zn, Sc, Ga, Mn und/oder Se als weiterem Metall.

11. Sekundärteilchenmassenspektrometer zur Analyse von Sekundärteilchen wie Sekundärionen und/oder nachionisierten neutralen Sekundärteilchen mit einer Flüssigmetallionenquelle zur Erzeugung eines Primärionenstrahls zur Bestrahlung einer Probe und Erzeugung von Sekundärteilchen,
**dadurch gekennzeichnet,**
**dass** es als Flüssigmetallionenquelle eine Flüssigmetallionenquelle nach einem der vorhergehenden Ansprüche aufweist,
sowie mit einer Filtervorrichtung, mit welcher aus dem von der Flüssigmetallionenquelle emittierten Primärionenstrahl sowohl eine von mehreren Bismutionenarten, deren Masse das einfache oder etwa bzw. genau ein Mehrfaches des monoatomaren, ein- oder mehrfach geladenen ) Bismutions beträgt, als massenreiner gefilterter Primärionenstrahl als auch eine von mehreren Ionenarten des weiteren Metalls als massenreiner gefilterter Primärionenstrahl herausfilterbar ist.

12. Sekundärteilchenmassenspektrometer nach dem vorhergehenden Anspruch, **dadurch gekennzeichnet, dass** der massereine gefilterte Bismutionenstrahl ausschließlich aus Ionen einer Art Biₙ^{p+} besteht, bei denen n ≥ 2 und p ≥ 1 ist und n und p jeweils eine natürliche Zahl ist, vorteilhafterweise Bi₃⁺.

13. Sekundärteilchenmassenspektrometer nach dem vorhergehenden Anspruch, **dadurch gekennzeichnet, dass** die für einen massenreinen Ionenstrahl herausgefilterten Ionen zu einer der folgenden Art gehören: Bi₂⁺, Bi₃⁺, Bi₄⁺, Bi₅⁺, Bi₆⁺, Bi₇⁺, Bi₃²⁺, Bi₅²⁺ oder Bi₇²⁺.

14. Sekundärteilchenmassenspektrometer nach einem der Ansprüche 12 und 13, **dadurch gekennzeichnet, dass** der Anteil der Bismutionen an dem von der Flüssigmetallionenquelle emittierten Primärionenstrahl ≥ 50 %, vorteilhafterweise ≥ 90 % ist.

15. Sekundärteilchenmassenspektrometer nach einem der Ansprüche 11 bis 14, **dadurch gekennzeichnet, dass** der Anteil der Ionen des weiteren Metalls an dem von der Flüssigmetallionenquelle emittierten Primärionenstrahl ≥ 0,5 % vorteilhafterweise ≥ 2 % ist.

16. Sekundärteilchenmassenspektrometer nach einem der Ansprüche 11 bis 15, **dadurch gekennzeichnet, dass** der Anteil der Ionen des weiteren Metalls an dem von der Flüssigmetallionenquelle emittierten Primärionenstrahl ≤ 50 %, vorteilhafterweise ≤ 10 % ist.

17. Sekundärteilchenmassenspektrometer nach einem der Ansprüche 11 bis 16, **dadurch gekennzeichnet, dass** der Anteil der Bismutionen und der Ionen des weiteren Metalls zusammen an dem von der Flüssigmetallionenquelle emittierten Primärionenstrahl ≥ 90 %, vorteilhafterweise ≥ 95 %, vorteilhafterweise ≥ 98 % ist.

18. Sekundärteilchenmassenspektrometrisches Analyseverfahren zur Analyse einer zu analysierenden Probe, wobei die Oberfläche der zu analysierenden Probe mit einem Primärionenstrahl bestrahlt wird,
**dadurch gekennzeichnet, dass** ein Primärionenstrahl erzeugt wird, der monoatomare oder polyatomare Ionen eines ersten Metalls und monoatomare Ionen eines weiteren Metalls enthält, wobei die Ionen des ersten Metalls ein Atomgewicht ≥ 190 u und die Ionen des weiteren Metalls ein Atomgewicht ≤ 90 u aufweisen,
abwechselnd aus dem Primärionenstrahl einerseits eine von mehreren Ionenarten des ersten Metalls als massenreiner gefilterter Primärionenstrahl und andererseits eine von mehreren Ionenarten des weiteren Metalls als massenreiner gefilterter Primärionenstrahl herausgefiltert werden und
jeweils das Sekundärteilchenspektrum mit dem die Ionen des ersten Metalls enthaltenden gefilterten Primärionenstrahl und das Sekundärteilchenspektrum mit dem die Ionen des weitere Metall enthaltenden gefilterten Primärionenstrahl bestimmt wird.

19. Analyseverfahren nach dem vorhergehenden Anspruch, **dadurch gekennzeichnet, daß** der Anteil der Ionen des ersten Metalls und der Ionen des weiteren Metalls zusammen an dem emittierten Primärionenstrahl ≥ 90 %, vorteilhafterweise ≥ 95 %, vorteilhafterweise ≥ 98 % beträgt.

20. Analyseverfahren nach dem vorhergehenden Anspruch, **dadurch gekennzeichnet, daß** das erste Metall eines der folgenden Metalle ist:
Bismut, Gold oder Blei.

21. Analyseverfahren nach dem vorhergehenden Anspruch, **dadurch gekennzeichnet, daß** das weitere Metall eines der folgenden Metalle ist:
Lithium, Beryllium, Bor, Natrium, Magnesium, Aluminium, Silizium, Kalium, Calcium, Scandium, Titan, Vanadium, Chrom, Mangan, Eisen, Kobalt, Nickel, Kupfer, Zink, Gallium, Germanium, Arsen, Selen, Rubidium und Yttrium.

22. Analyseverfahren nach dem vorhergehenden Anspruch, **dadurch gekennzeichnet, daß** der Analysestrahl durch eine Flüssigmetallionenquelle erzeugt wird, die zur Erzeugung des Primärionenstrahls eine Metalllegierung aufweist, die das erste Metall und das weitere Metall enthält.

23. Analyseverfahren nach einem der Ansprüche 18 bis 22, **dadurch gekennzeichnet, dass** ein Primärionenstrahl erzeugt wird, der polyatomare Bismutionen und Ionen eines weiteren Metalls enthält, wobei das weitere Metall ein Atomgewicht ≤ 90 u,
abwechselnd aus dem Primärionenstrahl einerseits eine von mehreren Bismutionenarten, deren Masse etwa oder genau ein Mehrfaches des monoatomaren, ein- oder mehrfach geladenen Bismutions Bi₁^{p+} beträgt, als massenreiner gefilterter Primärionenstrahl und andererseits eine von mehreren Ionenarten des weiteren Metalls als massenreiner gefilterter Primärionenstrahl herausgefiltert werden und
jeweils das Sekundärteilchenspektrum mit dem Bismut enthaltenden gefilterten Primärionenstrahl und das Sekundärteilchenspektrum mit dem das weitere Metall enthaltenden gefilterten Primärionenstrahl bestimmt wird.

24. Analyseverfahren nach einem der Ansprüche 18 bis 23, **dadurch gekennzeichnet, dass** das weitere Metall Mangan ist.

25. Analyseverfahren nach einem der Ansprüche 18 bis 22, **dadurch gekennzeichnet, dass** ein Primärionenstrahl erzeugt wird, der polyatomare Bismutionen und Ionen eines weiteren Metalls enthält, wobei das weitere Metall Mangan ist, abwechselnd aus dem Primärionenstrahl einerseits eine von mehreren Bismutionenarten, deren Masse etwa oder genau ein Mehrfaches des monoatomaren, ein- oder mehrfach geladenen Bismutions Bi₁^{p+} beträgt, als massenreiner gefilterter Primärionenstrahl und andererseits eine von mehreren Ionenarten des Mangans als massenreiner gefilterter Primärionenstrahl herausgefiltert werden und
jeweils das Sekundärteilchenspektrum mit dem Bismut enthaltenden gefilterten Primärionenstrahl und das Sekundärteilchenspektrum mit dem Mangan enthaltenden gefilterten Primärionenstrahl bestimmt wird

26. Analyseverfahren nach einem der Ansprüche 18 bis 25, **dadurch gekennzeichnet, dass** das natürliche oder angereicherte Hauptisotop des weiteren Metalls einen Anteil ≥ 80 %, vorteilhafterweise ≥ 90 %, vorteilhafterweise ≥ 95 % am Gesamtanteil des weiteren Metalls in dem Emissionsspektrum aufweist.

27. Analyseverfahren nach einem der Ansprüche 18 bis 26, **dadurch gekennzeichnet, dass** der Anteil der Bismutionen an dem emittierten Primärionenstrahl ≥ 50 %, vorteilhafterweise ≥ 90 % ist.

28. Analyseverfahren nach einem der Ansprüche 18 bis 27, **dadurch gekennzeichnet, dass** der Anteil der Ionen des weiteren Metalls an dem emittierten Primärionenstrahl ≥ 0,5 %, vorteilhafterweise ≥ 2 % ist.

29. Analyseverfahren nach einem der Ansprüche 18 bis 28, **dadurch gekennzeichnet, dass** der Anteil der Ionen des weiteren Metalls an dem emittierten Primärionenstrahl ≤ 50 %, vorteilhafterweise ≤ 10 % ist.

30. Analyseverfahren nach einem der Ansprüche 18 bis 29, **dadurch gekennzeichnet, dass** der Anteil der Bismutionen und der Ionen des weiteren Metalls zusammen an dem emittierten Primärionenstrahl ≥ 90 %, vorteilhafterweise ≥ 95 %, vorteilhafterweise ≥ 98 % ist.

31. Analyseverfahren nach einem der Ansprüche 18 bis 30, **dadurch gekennzeichnet, dass** der Bismutionen enthaltende gefilterte Primärionenstrahl Bismutionen einer Art Biₙ^{p+}, bei denen n ≥ 2 und p ≥ 1 ist und n und p jeweils eine natürliche Zahl ist, vorteilhafterweise Bi₃⁺ enthält oder daraus besteht.

32. Analyseverfahren nach dem vorhergehenden Anspruch, **dadurch gekennzeichnet, dass** der Primärionenstrahl und/oder der gefilterte Primärionenstrahl ein- oder zweiwertige Biₙ -Ionen, n ≥ 3 und natürliche Zahl, insbesondere Bi₃⁺ oder Bi₃²⁺, enthält oder daraus besteht.

33. Analyseverfahren nach einem der Ansprüche 18 bis 32, **dadurch gekennzeichnet, dass** der Analysestrahl durch eine Flüssigmetallionenquelle nach einem der Ansprüche 1 bis 10 erzeugt wird.

34. Analyseverfahren nach einem der Ansprüche 18 bis 33, **dadurch gekennzeichnet, dass** die beiden Sekundärteilchenspektren gemäß dem G-SIMS-Verfahren (Gentle-SIMS) ausgewertet und ein Sekundärteilchenspektrum der Probe erzeugt wird.

35. Analyseverfahren nach einem der Ansprüche 18 bis 34, **dadurch gekennzeichnet, dass** es mit einem Sekundärionenmassenspektrometer nach einem der Ansprüche 11 bis 17 durchgeführt wird.

36. Analyseverfahren nach einem der Ansprüche 18 bis 35, **dadurch gekennzeichnet, dass** die Analyse der erzeugten Sekundärteilchen in einem Magnetischen Sektorfeld-, einem Quadrupol- und/oder einem Flugzeit-Massenspektrometer erfolgt.

37. Analyseverfahren nach einem der Ansprüche 18 bis 36, **dadurch gekennzeichnet, dass** ein massenspektrometrisches Bild der Probenoberfläche und/oder ein Tiefenprofil der Probenoberfläche bestimmt wird.

38. Analyseverfahren nach einem der Ansprüche 18 bis 37, **dadurch gekennzeichnet, dass** die zu analysierende Probe oder Oberfläche organische Materialien aufweist.

39. Verwendung einer Flüssigmetallionenquelle, eines Massenspektrometers und/oder eines Analyseverfahrens nach einem der vorhergehenden Ansprüche zur Analyse von Proben und/oder Oberflächen, die organische Materialien aufweisen.

## Claims

1. Liquid metal ion source which contains bismuth in an alloy,
wherein the alloy contains a further metal having an atomic weight of ≤ 90 u, **characterised in that** the natural or enriched main isotope has a proportion of > 80% of the total proportion of the further metal in the liquid metal ion source.

2. Liquid metal ion source according to the preceding claim, **characterised in that** it contains manganese as a further metal.

3. Liquid metal ion source according to one of the preceding claims, **characterised in that** the natural or enriched main isotope of the further metal has a proportion of ≥ 90%, advantageously of ≥ 95% of the total proportion of the further metal in the liquid metal ion source.

4. Liquid metal ion source according to one of the preceding claims, **characterised in that** the bismuth content in the alloy is ≥ 50%, advantageously ≥ 90%.

5. Liquid metal ion source according to one of the preceding claims, **characterised in that** the content of the further metal in the alloy is ≥ 0.5%, advantageously ≥ 2%.

6. Liquid metal ion source according to one of the preceding claims, **characterised in that** the content of the further metal in the alloy is ≤ 50%, advantageously ≤ 10%.

7. Liquid metal ion source according to one of the preceding claims, **characterised in that** bismuth and the further metal together in the alloy have a proportion of ≥ 90%, advantageously ≥ 95%, advantageously ≥ 98%.

8. Liquid metal ion source according to one of the preceding claims, **characterised in that** the alloy is a low-melting alloy containing bismuth.

9. Liquid metal ion source according to one of the preceding claims, **characterised in that** the alloy has a melting point below the melting point of the pure bismuth or ≤ 270°C.

10. Liquid metal ion source according to one of the preceding claims, **characterised in that** the metallic alloy is an alloy having Ni, Cu, Zn, Sc, Ga, Mn and/or Se as a further metal.

11. Secondary particle mass spectrometer for analysing secondary particles such as secondary ions and/or post-ionised neutral secondary particles having a liquid metal ion source for generating a primary ion beam for irradiating a sample and generating secondary particles, **characterised in that**
it has a liquid metal ion source according to one of the preceding claims as a liquid metal ion source,
as well as having a filter device, with which both a primary ion beam which is filtered to be more mass-pure from several bismuth ion types, the mass of which amounts to the single or approximately or exactly a multiple of the monoatomic, singly or multiply charged bismuth ion, and a primary ion beam filtered to be more mass-pure from several ion types of the further metal, is able to be filtered from the primary ion beam emitted by the liquid metal ion source.

12. Secondary particle mass spectrometer according to the preceding claim, **characterised in that** the mass-pure filtered bismuth ion beam consists exclusively of ions of a Biₙ^{p+} type, where n is ≥ 2 and p is ≥ 1 and n and p are each a natural number, advantageously Bi₃⁺.

13. Secondary particle mass spectrometer according to the preceding claim, **characterised in that** the ions filtered out for a mass-pure ion beam belong to one of the following types: Bi₂⁺, Bi₃⁺, Bi₄⁺, Bi₅⁺, Bi₆⁺, Bi₇⁺, Bi₃²⁺, Bi₅²⁺ or Bi₇²⁺.

14. Secondary particle mass spectrometer according to one of claims 12 and 13, **characterised in that** the proportion of the bismuth ions in the primary ion beam emitted by the liquid metal ion source is ≥ 50%, advantageously ≥ 90%.

15. Secondary particle mass spectrometer according to one of claims 11 to 14, **characterised in that** the proportion of ions of the further metal in the primary ion beam emitted by the liquid metal ion source is ≥ 0.5%, advantageously ≥ 2%.

16. Secondary particle mass spectrometer according to one of claims 11 to 15, **characterised in that** the proportion of ions of the further metal in the primary ion beam emitted by the liquid metal ion source is ≤ 50%, advantageously ≤ 10%.

17. Secondary particle mass spectrometer according to one of claims 11 to 16, **characterised in that** the proportion of bismuth ions and ions of the further metal together in the primary ion beam emitted by the liquid metal ion source is ≥ 90%, advantageously ≥ 95%, advantageously ≥ 98%.

18. Secondary particle mass spectrometric analysis method to analyse a sample to be analysed, wherein the surface of the sample to be analysed is irradiated with a primary ion beam,
**characterised in that**
a primary ion beam is generated which contains monoatomic or polyatomic ions of a first metal and monoatomic ions of a further metal, wherein the ions of the first metal have an atomic weight of ≥ 190u and the ions of the further metal have an atomic weight of ≤ 90u,
on the one hand a primary ion beam which has been filtered to be more mass-pure from several ion types of the first metal, and on the other hand a primary ion beam which has been filtered to be more mass-pure from several ion types of the further metal, are filtered alternately from the primary ion beam and
the secondary particle spectrum having the filtered primary ion beam containing the ions of the first metal and the secondary particle spectrum having the filtered primary ion beam containing the ions of the further metal are determined respectively.

19. Analysis method according to the preceding claim, **characterised in that** the proportion of ions of the first metal and the ions of the further metal together in the emitted primary ion beam is ≥ 90%, advantageously ≥ 95%, advantageously ≥ 98%.

20. Analysis method according to the preceding claim, **characterised in that** the first metal is one of the following metals: bismuth, gold or lead.

21. Analysis method according to the preceding claim, **characterised in that** the further metal is one of the following metals: lithium, beryllium, boron, sodium, magnesium, aluminium, silicon, potassium, calcium, scandium, titanium, vanadium, chromium, manganese, iron, cobalt, nickel, copper, zinc, gallium, germanium, arsenic, selenium, rubidium, and yttrium.

22. Analysis method according to the preceding claim, **characterised in that** the analysis beam is generated by a liquid metal ion source which has a metal alloy for generating the primary ion beam, said metal alloy containing the first metal and the further metal.

23. Analysis method according to one of claims 18 to 22, **characterised in that** a primary ion beam is generated which contains polyatomic bismuth ions and ions of a further metal, wherein the further metal has an atomic weight of ≤ 90u,
on the one hand a primary ion beam filtered to be more mass-pure from several bismuth ion types, the mass of which amounts to approximately or exactly a multiple of the monoatomic, singly or multiply charged Bi₁^{p+} bismuth ion, and on the other hand a primary ion beam filtered to be more mass-pure from several ion types of the further metal, are filtered alternately from the primary ion beam and
the secondary particle spectrum having the filtered primary ion beam containing the bismuth and the secondary particle spectrum having the filtered primary ion beam containing the further metal is determined respectively.

24. Analysis method according to one of claims 18 to 23, **characterised in that** the further metal is manganese.

25. Analysis method according to one of claims 18 to 22, **characterised in that** a primary ion beam is generated which contains polyatomic bismuth ions and ions of a further metal, wherein the further metal is manganese, on the one hand a primary ion beam filtered to be more mass-pure from several bismuth ion types, the mass of which amounts to approximately or exactly a multiple of the monoatomic, singly or multiply charged Bi₁^{p+} bismuth ion, and on the other hand a primary ion beam filtered to be more mass-pure from several ion types of manganese, are filtered alternately from the primary ion beam, and the secondary particle spectrum having the filtered primary ion beam containing bismuth and the secondary particle spectrum having the filtered primary ion beam containing manganese is determined respectively.

26. Analysis method according to one of claims 18 to 25, **characterised in that** the natural or enriched main isotope of the further metal has a proportion of ≥ 80%, advantageously ≥ 90%, advantageously ≥ 95% of the total proportion of the further metal in the emission spectrum.

27. Analysis method according to one of claims 18 to 26, **characterised in that** the proportion of bismuth ions in the emitted primary ion beam is ≥ 50%, advantageously ≥ 90%.

28. Analysis method according to one of claims 18 to 27, **characterised in that** the proportion of ions of the further metal in the emitted primary ion beam is ≥ 0.5%, advantageously ≥ 2%.

29. Analysis method according to one of claims 18 to 28, **characterised in that** the proportion of ions of the further metal in the emitted primary ion beam is ≤ 50%, advantageously ≤ 10%.

30. Analysis method according to one of claims 18 to 29, **characterised in that** the proportion of bismuth ions and the ions of the further metal together in the emitted primary ion beam is ≥ 90%, advantageously ≥ 95%, advantageously ≥ 98%.

31. Analysis method according to one of claims 18 to 30, **characterised in that** the filtered primary ion beam containing bismuth ions contains bismuth ions of a Biₙ^{p+} type, where n ≥ 2 and p ≥ 1 and n and p are each a natural number, advantageously Bi₃⁺, or consists thereof.

32. Analysis method according to the preceding claim, **characterised in that** the primary ion beam and/or the filtered primary ion beam contains monovalent or divalent Biₙ ions, n ≥ 3 and a natural number, in particular Bi₃⁺ or Bi₃²⁺, or consists thereof.

33. Analysis method according to one of claims 18 to 32, **characterised in that** the analysis beam is generated by a liquid metal ion source according to one of claims 1 to 10.

34. Analysis method according to one of claims 18 to 33, **characterised in that** the two secondary particle spectra are evaluated according to the G-SIMS method (Gentle-SIMS) and a secondary particle spectrum of the sample is generated.

35. Analysis method according to one of claims 18 to 34, **characterised in that** it is carried out using a secondary ion mass spectrometer according to one of claims 11 to 17.

36. Analysis method according to one of claims 18 to 35, **characterised in that** the analysis of the generated secondary particles occurs in a magnetic sector field, a quadrupole and/or a time-of-flight mass spectrometer.

37. Analysis method according to one of claims 18 to 36, **characterised in that** a mass spectrometric image of the sample surface and/or a depth profile of the sample surface is determined.

38. Analysis method according to one of claims 18 to 37, **characterised in that** the sample or surface to be analysed has organic materials.

39. Use of a liquid metal ion source, a mass spectrometer and/or an analysis method according to one of the preceding claims to analyse samples and/or surfaces which have organic materials.

## Revendications

1. Source d'ions à métal liquide, qui contient du bismuth dans un alliage, l'alliage contenant un métal supplémentaire ayant une masse atomique ≤ 90 u, **caractérisée en ce que** l'isotope principal est présent dans la source d'ions à métal liquide selon une proportion > 80 % par rapport à la totalité du métal supplémentaire.

2. Source d'ions à métal liquide selon la revendication précédente, **caractérisée en ce qu'**elle contient du manganèse en tant que métal supplémentaire.

3. Source d'ions à métal liquide selon l'une des revendications précédentes, **caractérisée en ce que** l'isotope principal naturel ou enrichi du métal supplémentaire est présent dans la source d'ions à métal liquide selon une proportion ≥ 90 %, avantageusement ≥ 95 %, par rapport à la totalité du métal supplémentaire.

4. Source d'ions à métal liquide selon l'une des revendications précédentes, **caractérisée en ce que** la teneur de l'alliage en bismuth est ≥ 50 %, avantageusement ≥ 90 %.

5. Source d'ions à métal liquide selon l'une des revendications précédentes, **caractérisée en ce que** la teneur de l'alliage en le métal supplémentaire est ≥ 0,5 %, avantageusement ≥ 2 %.

6. Source d'ions à métal liquide selon l'une des revendications précédentes, **caractérisée en ce que** la teneur de l'alliage en le métal supplémentaire est ≤ 50 %, avantageusement ≤ 10 %.

7. Source d'ions à métal liquide selon l'une des revendications précédentes, **caractérisée en ce que** le bismuth et le métal supplémentaire sont ensemble présents dans l'alliage selon une proportion ≥ 90 %, avantageusement ≥ 95 %, avantageusement ≥ 98 %.

8. Source d'ions à métal liquide selon l'une des revendications précédentes, **caractérisée en ce que** l'alliage est un alliage à bas point de fusion, contenant du bismuth.

9. Source d'ions à métal liquide selon l'une des revendications précédentes, **caractérisée en ce que** l'alliage présente un point de fusion inférieur au point de fusion du bismuth pur, ou ≤ 270°C.

10. Source d'ions à métal liquide selon l'une des revendications précédentes, **caractérisée en ce que** l'alliage métallique est un alliage avec Ni, Cu, Zn, Sc, Ga, Mn et/ou Se en tant que métal supplémentaire.

11. Spectromètre de masse à particules secondaires, pour l'analyse de particules secondaires, telles que les ions secondaires et/ou les particules secondaires neutres post-ionisées, avec une source d'ions à métal liquide pour la production d'un faisceau d'ions primaires, pour irradier un échantillon et produire des particules secondaires, **caractérisé en ce qu'**il comprend en tant que source d'ions à métal liquide une source d'ions à métal liquide selon l'une des revendications précédentes, et comportant aussi un dispositif de filtration, à l'aide duquel il est possible d'extraire par filtration, à partir du faisceau d'ions primaires émis par la source d'ions à métal liquide, tant l'une de plusieurs espèces d'ions bismuth, dont la masse correspond à une fois, ou approximativement ou exactement à un multiple de celle de l'ion bismuth monoatomique, une ou plusieurs fois chargé, sous forme d'un faisceau d'ions primaires filtré à masse pure, que l'une de plusieurs espèces d'ions du métal supplémentaire, en tant que faisceau d'ions primaires filtré à masse pure.

12. Spectromètre de masse à particules secondaires selon la revendication précédente, **caractérisé en ce que** le faisceau d'ions bismuth filtré à masse pure est constitué exclusivement d'ions d'une espèce de Biₙ^{p+}, dans lequel n ≥ 2 et p ≥ 1, et n et p représentent chacun un nombre entier, avantageusement Bi₃⁺.

13. Spectromètre de masse à particules secondaires selon la revendication précédente, **caractérisé en ce que** les ions extraits par filtration pour un faisceau d'ions à masse pure appartiennent à l'une des espèces suivantes : Bi₂⁺, Bi₃⁺, Bi₄⁺, Bi₅⁺, Bi₆⁺, Bi₇⁺, Bi₃²⁺, Bi₅²⁺ ou Bi₇²⁺.

14. Spectromètre de masse à particules secondaires selon l'une des revendications 12 et 13, **caractérisé en ce que** la proportion des ions bismuth, par rapport au faisceau d'ions primaires émis par la source d'ions à métal liquide, est ≥ 50 %, avantageusement ≥ 90 %.

15. Spectromètre de masse à particules secondaires selon l'une des revendications 11 à 14, **caractérisé en ce que** la proportion des ions du métal supplémentaire, par rapport au faisceau d'ions primaires émis par la source d'ions à métal liquide, est ≥ 0,5 %, avantageusement ≥ 2 %.

16. Spectromètre de masse à particules secondaires selon l'une des revendications 11 à 15, **caractérisé en ce que** la proportion des ions du métal supplémentaire, par rapport au faisceau d'ions primaires émis par la source d'ions à métal liquide, est ≤ 50 %, avantageusement ≤ 10 %.

17. Spectromètre de masse à particules secondaires selon l'une des revendications 11 à 16, **caractérisé en ce que** la proportion des ions bismuth et des ions du métal supplémentaire, pris ensemble, par rapport au faisceau d'ions primaires émis par la source d'ions à métal liquide, est ≥ 90 %, avantageusement ≥ 95 %, avantageusement ≥ 98 %.

18. Procédé d'analyse par spectrométrie de masse à particules secondaires pour l'analyse d'un échantillon à analyser, dans lequel la surface de l'échantillon à analyser est irradiée par un faisceau d'ions primaires,
**caractérisé en ce qu'**on produit un faisceau d'ions primaires, qui contient des ions monoatomiques ou polyatomiques d'un premier métal et des ions monoatomiques d'un métal supplémentaire, les ions du premier métal présentant une masse atomique ≥ 190 u et les ions du métal supplémentaire présentant une masse atomique ≤ 90 u,
en alternance, on extrait par filtration, à partir du faisceau d'ions primaires, d'une part l'une de plusieurs espèces du premier métal, en tant que faisceau d'ions primaires filtré à masse pure, et d'autre part l'une de plusieurs espèces d'ions du métal supplémentaire, en tant que faisceau d'ions primaires filtré à masse pure, et
on détermine respectivement le spectre des particules secondaires avec le faisceau d'ions primaires filtré, contenant les ions du premier métal, et le spectre des particules secondaires avec le faisceau d'ions primaires filtré, contenant les ions du métal supplémentaire.

19. Procédé d'analyse selon la revendication précédente, **caractérisé en ce que** la proportion des ions du premier métal et des ions du métal supplémentaire, pris ensemble, est, par rapport au faisceau d'ions primaires émis, ≥ 90 %, avantageusement ≥ 95 %, avantageusement ≥ 98 %.

20. Procédé d'analyse selon l'une des revendications précédentes, **caractérisé en ce que** le premier métal est l'un des métaux suivants : bismuth, or ou plomb.

21. Procédé d'analyse selon la revendication précédente, **caractérisé en ce que** le métal supplémentaire est l'un des métaux suivants ; lithium, béryllium, bore, sodium, magnésium, aluminium, silicium, potassium, calcium, scandium, titane, vanadium, chrome, manganèse, fer, cobalt, nickel, cuivre, zinc, gallium, germanium, arsenic, sélénium, rubidium et yttrium.

22. Procédé d'analyse selon la revendication précédente, **caractérisé en ce que** le faisceau d'analyse est produit par une source d'ions à métal liquide, qui comprend, pour la production du faisceau d'ions primaires, un alliage métallique qui contient le premier métal et le métal supplémentaire.

23. Procédé d'analyse selon l'une des revendications 18 à 22, **caractérisé en ce qu'**on produit un faisceau d'ions primaires qui contient des ions bismuth polyatomiques et des ions d'un métal supplémentaire, le métal supplémentaire ayant une masse atomique ≤ 90 u,
en alternance, on extrait par filtration, à partir du faisceau d'ions primaires, d'une part l'une de plusieurs espèces d'ions bismuth, dont la masse est approximativement ou exactement égale à un multiple celle de de l'ion bismuth Bi₁^{p+} monoatomique, une ou plusieurs fois chargé, en tant que faisceau d'ions primaires filtré à masse pure, et d'autre part l'une de plusieurs espèces d'ions du métal supplémentaire, en tant que faisceau d'ions primaires filtré à masse pure, et
on détermine respectivement le spectre des particules secondaires avec le faisceau d'ions primaires filtré, contenant le bismuth, et le spectre des particules secondaires avec le faisceau d'ions primaires filtré, contenant le métal supplémentaire.

24. Procédé d'analyse selon l'une des revendications 18 à 23, **caractérisé en ce que** le métal supplémentaire est le manganèse.

25. Procédé d'analyse selon l'une des revendications 18 à 22, **caractérisé en ce qu'**on produit un faisceau d'ions primaires qui contient des ions bismuth polyatomiques et des ions d'un métal supplémentaire, le métal supplémentaire étant le manganèse,
en alternance on extrait par filtration, à partir du faisceau d'ions primaires, d'une part l'une de plusieurs espèces de bismuth, dont la masse est approximativement ou exactement égale à un multiple de celle de l'ion bismuth Bi₁^{p+} monoatomique, une ou plusieurs fois chargé, en tant que faisceau d'ions primaires filtré à masse pure, et d'autre part l'une de plusieurs espèces de manganèse, en tant que faisceau d'ions primaires filtré à masse pure, et
on détermine respectivement le spectre des particules secondaires avec le faisceau d'ions primaires filtré, contenant du bismuth, et le spectre de particules secondaires avec le faisceau d'ions primaires filtré, contenant du manganèse.

26. Procédé d'analyse selon l'une des revendications 18 à 25, **caractérisé en ce que** l'isotope principal naturel et enrichi du métal supplémentaire est présent, par rapport à la quantité totale du métal supplémentaire dans le spectre d'émission, selon une proportion ≥ 80 %, avantageusement ≥ 90 %, avantageusement ≥ 95 %.

27. Procédé d'analyse selon l'une des revendications 18 à 26, **caractérisé en ce que** la proportion des ions bismuth, par rapport au faisceau d'ions primaires émis, est ≥ 50 %, avantageusement ≥ 90 %.

28. Procédé d'analyse selon l'une des revendications 18 à 27, **caractérisé en ce que** la proportion des ions du métal supplémentaire, par rapport au faisceau d'ions primaires émis, est ≥ 0,5 %, avantageusement ≥ 2 %.

29. Procédé d'analyse selon l'une des revendications 18 à 28, **caractérisé en ce que** la proportion des ions du métal supplémentaire, par rapport au faisceau d'ions primaires émis, est ≤ 50 %, avantageusement ≤ 10 %.

30. Procédé d'analyse selon l'une des revendications 18 à 29, **caractérisé en ce que** la proportion des ions bismuth et des ions du métal supplémentaire, pris ensemble, par rapport au faisceau d'ions primaires émis, est ≥ 90 %, avantageusement ≥ 95 %, avantageusement ≥ 98 %.

31. Procédé d'analyse selon l'une des revendications 18 à 30, **caractérisé en ce que** le faisceau d'ions primaires filtré, contenant des ions bismuth d'une espèce Biₙ^{p+}, dans lesquels n ≥ 2 et p ≥ 1, et n et p représentent chacun un nombre entier, contient avantageusement Bi₃⁺ ou en est constitué.

32. Procédé d'analyse selon la revendication précédente, **caractérisé en ce que** le faisceau d'ions primaires et/ou le faisceau d'ions primaires filtré contient des ions Biₙ monovalents ou divalents, n ≥ 3 et est un nombre entier, en particulier Bi₃⁺ ou Bi₃²⁺, ou en est constitué.

33. Procédé d'analyse selon l'une des revendications 18 à 32, **caractérisé en ce que** le faisceau d'analyse est produit par une source d'ions à métal liquide selon l'une des revendications 1 à 10.

34. Procédé d'analyse selon l'une des revendications 18 à 33, **caractérisé en ce que** les deux spectres de particules secondaires sont évalués par la méthode G-SIMS (Gentle-SIMS), et un spectre de particules secondaires de l'échantillon est généré.

35. Procédé d'analyse selon l'une des revendications 18 à 34, **caractérisé en ce qu'**il est mis en oeuvre avec un spectromètre de masse à ions secondaires selon l'une des revendications 11 à 17.

36. Procédé d'analyse selon l'une des revendications 18 à 35, **caractérisé en ce que** l'analyse des particules secondaires produites est effectuée dans un spectromètre de masse à champ de secteurs magnétiques, un spectromètre de masse quadripolaire et/ou un spectromètre de masse à temps de vol.

37. Procédé d'analyse selon l'une des revendications 18 à 36, **caractérisé en ce qu'**on détermine une image de spectrométrie de masse de la surface de l'échantillon et/ou un profil en profondeur de la surface de l'échantillon.

38. Procédé d'analyse selon l'une des revendications 18 à 37, **caractérisé en ce que** l'échantillon ou la surface à analyser présente des matériaux organiques.

39. Utilisation d'une source d'ions à métal liquide d'un spectromètre de masse et/ou d'un procédé d'analyse selon l'une des revendications précédentes pour l'analyse d'échantillons et/ou de surfaces qui comprennent des matériaux organiques.
